# EUROPEAN PATENT SPECIFICATION

(11) **EP 2 225 596 B1**
(45) Date of publication and mention of the grant of the patent: **14.02.2024**
(21) Application number: 08861901.0
(22) Date of filing: 16.12.2008
(51) Int. Cl.: G02B 6/12, B29D 11/00, H04N 23/57, H01L 27/146

(54) **SPACER ELEMENT AND METHOD FOR MANUFACTURING A SPACER ELEMENT**
DISTANZSTÜCK UND HERSTELLUNGSVERFAHREN FÜR EIN DISTANZSTÜCK
ÉLÉMENT D'ÉCARTEMENT ET SON PROCÉDÉ DE FABRICATION

(30) Priority: 19.12.2007 US 14801 P; 25.07.2008 US 180175
(43) Date of publication of application: 08.09.2010
(73) Proprietor: Heptagon Micro Optics Pte. Ltd., Singapore 539219 (SG)
(72) Inventor: ROSSI, Markus, 8645 Jona (CH); RUDMANN, Hartmut, 8645 Jona (CH); SPRING, Nicola, 8037 Wipkingen (CH); BIETSCH, Alexander, 8800 Thalwil (CH)
(74) Representative: Marks & Clerk LLP
(86) International application number: PCT/CH2008/000530
(87) International publication number: WO 2009/076786

(56) References cited:
- EP-A- 1 244 151
- EP-A2- 1 036 415
- EP-A2- 1 070 972
- WO-A-00/73090
- WO-A-2004/027880
- JP-A- S5 334 473
- JP-A- 2003 329 808
- KR-B1- 100 691 184
- US-A1- 2003 002 809
- US-A1- 2007 200 132

## Description

### FIELD OF THE INVENTION

The invention is in the field of manufacturing integrated optical devices with one or more optical elements, e.g. refractive and/or diffractive lenses, in a well defined spatial arrangement on wafer scale by means of a replication process. More concretely, it deals with a spacer element.

### BACKGROUND OF THE INVENTION

Integrated optical devices are, for example, camera devices, optics for camera devices, or collimating optics for flash lights, especially for camera mobile phones. Manufacture of optical elements by replication techniques, such as embossing or molding, is known. Of special interest for a cost effective mass production are wafer-scale manufacturing processes where an array of optical elements, e.g. lenses, is fabricated on a disk-like structure (wafer) by means of replication. In most cases, two or more wafers with optical elements attached thereto are stacked in order to form a wafer scale package or wafer stack where optical elements attached to different substrates are aligned. Subsequent to replication, this wafer structure can be separated into individual optical devices (dicing).

A wafer or substrate in the meaning used in this text is a disc or a rectangular plate or a plate of any other shape of any dimensionally stable, often transparent material. The diameter of a wafer disk is typically between 5 cm and 40 cm, for example between 10 cm and 31 cm. Often it is cylindrical with a diameter of either 2, 4, 6, 8 or 12 inches, one inch being about 2.54 cm. The wafer thickness is for example between 0.2 mm and 10 mm, typically between 0.4 mm and 6 mm.

Integrated optical devices include functional elements, at least one of which is an optical element, stacked together along the general direction of light propagation. Thus, light travelling through the device passes through the multiple elements sequentially. These functional elements are arranged in a predetermined spatial relationship with respect to one another (integrated device) such that further alignment with each other is not needed, leaving only the optical device as such to be aligned with other systems.

Such optical devices can be manufactured by stacking wafers that comprise functional, e.g. optical, elements in a well defined spatial arrangement on the wafer. Such a wafer scale package (wafer stack) comprises at least two wafers that are stacked along the axis corresponding to the direction of the smallest wafer dimension (axial direction) and attached to one another. At least one of the wafers bears replicated optical elements, and the other can comprise or can be intended to receive optical elements or other functional elements, such as electro-optical elements (e.g. CCD or CMOS sensor arrays). The wafer stack thus comprises a plurality of generally identical integrated optical devices arranged side by side.

By spacer means, e.g. a plurality of separated spacers or an interconnected spacer matrix as disclosed in US 2003/0010431 or WO 2004/027880, the wafers can be spaced from one another, and optical elements can also be arranged between the wafers on a wafer surface facing another wafer. Thus, a spacer is sandwiched between a top wafer and a bottom wafer. This arrangement may be repeated with further wafers and intermediary spacers.

EP 1 244 151 A describes a spacer wafer used in the wafer-scale fabrication of integrated optical devices. The spacer may be made of resin, glass, silicon or the like.

In a similar arrangement, US 2003/002809 A1 describes layers that seem to have no other purpose than to distance other layers from one another.

WO 2004/027880 A also discloses spacer wafers, denoted "micro-spacers", but providing the same function as the spacers of EP 1 244 151 A.

US 2007/0200132 A1 shows the wafer-scale manufacturing of optoelectronic devices, in which a spacer wafer is arranged between an upper and a lower wafer, the lower wafer carries electrical bonding pads for later electrical connection. The spacer wafer comprises cavities ("indentations") or through holes which, when the spacer wafer is placed onto the lower wafer, leave room for the bonding pads. When dicing the resulting wafer stack, the top and spacer wafer are separated along different lines than the lower wafer, thereby exposing the bonding pads. In the preceding step of gluing the wafers and the spacer against one another, the bonding pads may not be covered with adhesive.

WO 00/73090 shows wafer to wafer bonding using microstructures arranged along the contact surfaces of the wafers, which cause a bonding material to fill the microstructures by capillary forces. Two wafers are brought into contact and held together mechanically, then the bonding material is inserted into a trench surrounding a die, and then the bonding material penetrates into the capillary space between the wafers.

JP 2003329808 describes a combined lens array is formed by superposing a plurality of lens arrays having a plurality of optical curved surfaces on each other in the state of aligning the optical axes of the corresponding optical curved surfaces. Interposing sections form gaps between the optical curved surfaces of the superposed lens arrays.

EP1036415 B1 describes integrating multiple optical elements formed by bonding substrates containing optical elements together or by providing optical elements on either side of the wafer substrate.

KR100691184 B1 describes a bonding method for stacking wafer scale lenses and the wafer scale lens.

EP1070972 B1 describes a method of making a lens assembly with a plurality of lens arrays having a plurality of lenslets and at least one spacer having a plurality of holes.

JP-A-53034473 is also a known document in the related art.

### DESCRIPTION OF THE INVENTION

It is an object of the invention to create a spacer wafer and a method for manufacturing a wafer stack element which allow for a simple and cost-effective manufacturing process. A further object is to provide spacer wafers improving the quality and yield of the resulting wafer stack.

These objects are achieved by a spacer wafer according to independent claim 1, a wafer stack according to claim 9 and a method of manufacturing a wafer stack element according to claim 10.

The spacer wafer for a wafer stack comprises a spacer body with a first surface and a second surface, and is intended to be sandwiched between a first wafer and a second wafer. That is, the spacer is to keep a first wafer placed against the first surface and a second wafer placed against the second surface at a constant distance from each other. The spacer furthermore provides openings arranged such that functional elements of the first wafer and of the second wafer can be aligned with the openings.

Outside the scope of the present invention, a method for manufacturing a spacer wafer comprises the steps of
- providing a forming tool;
- forming the spacer according to the form of the tool by means of a shape replication process.

Outside the scope of the present invention, the step of forming the spacer comprises the steps of
- providing spacer material in a deformable, that is, liquid or viscous state;
- defining a shape of the spacer material as a negative of the tool;
- hardening the spacer material, thereby creating the spacer wafer; and
- separating the spacer wafer from the tool.

The spacer material is preferably hardend by curing. Curing is a term in polymer chemistry and Process Engineering that refers to the toughening or hardening of a polymer material by cross-linking of polymer chains, brought about by chemical additives, ultraviolet radiation, Electron beam (EB) or heat. The spacer thus may be made of a synthetic organic or inorganic base material that is first in a liquid or viscous state and is curable. One preferred base material is epoxy. The base material may optionally be mixed with a dye for colouring, and/or a filler material such as glass fibres or the like. The material is cured - for example UV cured - while the forming tool is still in place. UV light curing is a fast process that allows for a good control of the hardening process.

Preferably, the spacer is made of a thermoplastic material. It is heated and then shaped by the shape replication process, e.g. by stamping or moulding, including injection moulding. Upon cooling down, the material hardens in the desired shape of the spacer.

The replication process may be an embossing or stamping process, where the deformable or viscous or liquid component spacer material is placed on a surface of a substrate or on the forming tool. That is, the substrate material is arranged between the tool and the substrate. The substrate is typically a stiff plate which is also wafer scale in size, wherein 'wafer scale' refers to the size of disk like or plate like substrates of sizes comparable to semiconductor wafers, such as disks having diameters between 2 inches and 12 inches. Then, the replication tool or forming tool is moved or pressed against the substrate. The movement stops at the latest once the forming tool abuts against the substrate.

As an alternative, the replication process can be a moulding process. In a moulding process, in contrast, the forming tool from which the spacer is shaped, is first pressed onto the surface of a substrate to form a defined cavity which is then filled through a moulding process.

In a further preferred embodiment lying outside the scope of the present invention, the spacer material is placed on the tool, and an anti-adhesion layer is arranged between the substrate plate and the spacer material, before moving the substrate against the tool. The anti-adhesion layer allows the hardened spacer to separate easily from the substrate plate. The anti-adhesion layer can be a thin foil, e.g. of mylar, or can be an anti-adhesion film of material (e.g. Teflon) applied by spraying or wetting the substrate. The anti-adhesion layer can be left on the spacer after curing.

Preferably, the step of providing a forming tool comprises forming the tool according to the shape of a master form by means of a shape replication process. The tool can then be supplemented to comprise a back plate for increasing stiffness and robustness.

At least one of the first and second surface, comprises edges separating said surface from the openings, and the step of hardening the spacer material comprises shrinking the thickness of the spacer wafer in areas near the edges more than at the edges themselves. This results in a spacer wherein the thickness of the spacer wafer at the edges exceeds the thickness of the spacer wafer at surface locations around the edges. In other words, the edges are elevated with regard to the average thickness of the spacer. In a preferred embodiment of the invention, the elevation of the edges with regard to the surrounding surface is around one to ten micrometers. The spacer itself typically has a thickness of 100 to 1500 micrometers.

When a stack is created using the spacer, a bonding agent, i.e. a liquid or viscous glue, is applied to the surface of the spacer. Due to the elevation of the edges, the free space between a spacer and the adjoining wafer tapers out towards the edges. The liquid bonding agent is drawn by capillary forces towards the edges. This helps to ensure that, even if air bubbles are trapped in the bonding agent, no air bubbles remain near or at the edges. Rather, any air is forced away from the edges by the bonding agent being drawn there. As a result, even after dicing the wafer stack into the individual units, the edges are well sealed.

Even if the there is no pronounced elevation at the edges, or no elevation at all, the bonding agent will spread along the gap between two wafers, as long as there is a reservoir of bonding agent. Such a reservoir can be a drop or a blob of bonding agent deposited on one of the wafers, on a surface that later is moved against another wafer, and/or in a cavity, but such that the drop comes into contact with the other wafer when the wafers are placed against one another. The gap between the wafer surfaces that are in close proximity gets filled, by capillary forces, with the glue/bonding agent, and conversely the air is displaced to the cavities.

This is a comparatively local effect, in that the exchange of air and glue happens, for example, within a range of ca. 1 mm (millimetres) to less than 3 mm (for a particular, typical bonding agent). For example, if the an area without cavities extends for about 3 mm between given cavities, in one dimension, then bubbles may form at undefined, arbitrary locations along these 3 mm. Introducing a cavity in-between, i.e. in the middle, at 1.5 mm from the existing cavities, causes the air to collect at the cavities, i.e. in well-defined places.

These additional cavities or depressions shall also be called *flow control cavities* in view of their function. This does, however, not preclude them from having other functions as well. In contrast, the other cavities or openings shall be called *device cavities,* as they are used in relation with the main function of an optoelectronic or microelectronic element, e.g. for the passage of light. The gap or narrow space between the two surfaces that are to be glued together (e.g. between a spacer and a substrate) shall simply be called *gap.*

A further function of the depressions or cavitites arises if, in a preferred embodiment of the invention, they are contiguous and are located along dicing lines for cutting the wafer. If the spacer wafer is cut without having beeen glued to a top wafer, jagged edges caused by the dicing saw are located in the depressed areas and not in the topmost areas such as the edge regions. When, later on, glueing a single spacer wafer by its top surface to a further surface takes place, the jagged edges do not interfere with the alignment of the top surface to the further surface.

When only the device cavities or openings required for the optical elements created later are present, then any excess glue shall accumulate at the edge of the cavities. This requires a certain precision of the glue dosage method, since too much excess glue will eventually fill the cavities to an extent that interferes with the function of an optical or electronic element or the light path in the cavity. However, if the additional cavities are present, excess glue shall run into them, where it does not interfere. Also, air and excess glue flows faster through cavities shaped as channels, which improves the speed of the process and the homogeneity of the glue thickness.

In order to control the flow of glue even better, in a preferred variant of the invention, the glue is disposed onto or into the flow control cavities. The placement of the glue is subject to the precondition that the glue wets the gap between the two surfaces that are to be glued together. In consequence, the glue is drawn into the gap by the capillary forces, until it reaches the end of the gap, i.e. at the edge of a device cavity. The borderline of the glue is well defined by these edges. Excess glue remains in the flow control cavities where it comes from. The distance that the glue can flow is of course limited by the amount of available glue, its viscosity and further physical parameters such as the wetting properties of the glue and the wafer materials.

Flow control cavities are comparatively easy to manufacture in a wafer (not only a spacer wafer) made by means of a shape replication process. However, flow control cavities and the corresponding bonding method can also be applied to wafers made with other processes and materials.

Since the spacer is formed by a shape replication process (rather than machining it from a glass plate), it is possible to form virtually arbitrary shapes in the spacer's surface and to give the openings arbitrary shapes, except for undercut shapes. Thus, according to the invention, at least one of the top or bottom surfaces of the master and therefore also of a corresponding spacer comprises grooves or channels for collecting surplus glue and air, or channels for connecting the opening in the spacer to the ambient air after forming the wafer stack. Such channels may be formed in the top surface and/or in the bottom surface of the spacer. A wafer stack is created by stacking at least one spacer according to the invention with at least one wafer carrying functional elements, according to claim 9. Corresponding integrated optical devices are manufactured as wafer stack elements from a wafer stack by separating or dicing the wafer stack into a plurality of wafer stack elements. A wafer stack may be an intermediate product, comprising e.g. one wafer and one spacer. Such a stack can be provided, at a later time, with a further wafer distanced by the spacer. Or the stack can be diced into separate elements which are assembled, using the spacers on an individual basis.

A wafer comprises, on the one hand, **spacer areas** surrounding the openings (or device cavities), and on the other hand the remaining area. The remaining area or **connection area** is made at least half as thick, preferably less than 20% of the total thickness of the wafer. In absolute terms, the connection area is preferably at least 0.2 mm to 0.3 mm thick, with the total thickness ranging from e.g. 0.5 mm to 1 mm to 1.5 mm. As a result, the mechanical stability of the wafer is sufficient to define the relative location of the openings and surrounding spacer areas. However, since the connection area is relatively thin, the following advantages result:
▪ the wafer is less likely to warp than a wafer with full thickness all over its area. This becomes particularly important, the thicker the wafer gets, e.g. for a thicknesses of more then 1 mm.
▪ the wafer is less likely to expand in the xy-direction, i.e., within the plane of the wafer, due to material expansion after removing the wafer from the mould.
▪ the effective wall thickness at any part of the wafer is reduced. That is, the distance from the innermost points of the wafer to the wafer surface is reduced. As a result, more UV light used for hardening reaches the innermost points, and the hardening process is improved. The time for hardening that occurs after the UV-irradiation, when the wafer is no longer in the mould, and which may also involve undesired deformation of the wafer, is decreased.

Connection areas - typically grooves shaped in at least one surface of the wafer, can be incorporated in spacer wafers, but also in wafers that carry functional elements, such as a moulded wafer incorporating lenses moulded into or onto the wafer.

Preferably, the spacer areas comprise small, elevated protrusions with an essentially flat surface, parallel to the plane of the spacer wafer, that defines the overall thickness of the spacer wafer. This may be necessary for applications in which the spacer thickness has to be well-defined.

Preferably, the connection area comprises a right angle grid of channels. This leaves rectangular, mesa-like spacer areas. The channels are preferably arranged to be in a location where the wafer stack (defined?) will be cut into individual elements, i.e., along the dicing lines. For this reason, the channels may also be called dicing channels. The following further advantage results:
▪ The dicing saw has to cut through less spacer wafer material, decreasing the wear on the saw blade, and/or allowing for faster cutting.
▪ An optional improvement in the sawing process is the reduction of the sawing steps in dicing: Several layers of meterial can be sawed through without having to adapt the sawing process to the change of material.

Further preferably, the connection area comprises through holes, separated by bridge elements that join the spacer areas. This further reduces the amount of material in the connection area that may contribute to warping and other deformation of the spacer wafer.

Preferably, the width of a dicing channel is around 0.2 mm, i.e. similar to the thickness of a dicing saw blade. Preferably, the channel width is slightly larger, allowing for a corresponding misalignment of the channel with the saw.

Combining the advantages of the deep connecting area with the requirement that a flow control cavity be not too deep leads to a hybrid.

Herein, the surface area comprises on the one hand protrusions defining the thickness of the spacer wafer, and, on the other hand, local flow control cavities for depositing glue and/or for absorbing excess glue: The relatively deep connecion area would be too deep to allow an adequate amount of glue to reach a substrate being glued onto the spacer area. Therefore, these one or more local flow control cavities are arranged in the top surface of the spacer ares. Glue is deposited in these flow control cavities, and the flow of glue as already explained results when joining the spacer to another surface.

In the replication process for creating the spacer wafer or the tool, the deep connecting areas may cause problems by trapping air. For this reason, instead of only pouring the replication over the mould (i.e., the tool or the master form), the following steps are performed:
- initially, spraying at least part of the replication material onto the mould, thereby wetting the entire replication surface and preferably filling up deep features. On the one hand, this fills deeper features of the mould without trapping air, on the other hand, the wetting properties of the mould surface are greatly improved.
- subsequently, distributing liquid replication material over the mould. This is preferably done by placing a predetermined quantity of the liquid replication material onto the mould, at least approximately in the middle of the mould, and then moving a plate towards the mould (or vice versa), causing the replication material to flow outwards, covering the entire mould and pushing air out.

This method of initially spraying the mould with replication material in order to improve the wetting properties with regard to the subsequently applied replication material is of course applicable to any replication stage, in particular to one involving deep and narrow features.

The glue flows along the dry surface of the mould with a certain wetting angle or contact angle (i.e., the internal angle, inside the glue, between the mould surface and the glue surface). For a dry mould this angle typically is larger than 90°. As a result, glue flowing around a shape of the mould and meeting again is likely to trap air between the converging glue.

Conversely, if the mould surface is coated with at least a thin film of glue, the wetting angle between the bulk of glue flowing over the mould surface is small, typically well below 90°. As a result, glue flowing around a shape first meets at a point at the surface of the shape, and no air is trapped in-between the two converging parts of the glue.

Furthermore, not only the spacers, but also the other elements of the wafer stack may be made of a plastic material and may be fabricated by a shape replication process. Such other elements are in particular the wafers carrying the functional elements, and optical functional elements (refractive and/or diffractive lenses) themselves. The plastic material can be a resin, epoxy or thermoplastic material, and preferably is curable, in particular UV-curable.

The plastic material chosen is preferably designed to withstand temperatures of up to ca. 260°C in order to e.g. allow for reflow soldering of the wafer stack and a printed circuit it is mounted on.

As a result, by replacing the usual glass material used for wafer substrates by the plastic material, the different wafer types can be manufactured by the same or similar processes, which simplifies the fabrication process and reduces the number of tools and installations used.

Embodiments of the invention are defined according to the dependent patent claims.

Features of the method claims may be combined with features of the device claims and vice versa.

### BRIEF DESCRIPTION OF THE DRAWINGS

The subject matter of the invention will be explained in more detail in the following text with reference to preferred exemplary embodiments which are illustrated in a schematical manner the attached drawings, in which:
- Figure 1: shows a top view of a master form;
- Figure 2: shows a lateral sectional view of a section of a master form;
- Figure 3: shows a lateral sectional view of a section of a master form with a tool shaped from the master form;
- Figure 4: shows a lateral sectional view of a section of a tool with replication material;
- Figure 5: shows a lateral sectional view of a section of a tool, with replication material shaped between the tool and a plate;
- Figure 6: shows a lateral sectional view of a section of a resulting spacer;
- Figure 7: shows an elevated view of a spacer;
- Figure 8: shows a lateral sectional view of a detail of a spacer;
- Figure 9: shows a lateral sectional view of a detail of a wafer stack;
- Figure 10: shows a lateral sectional view of a further embodiment of a master form;
- Figure 11: shows a lateral sectional view of a corresponding detail of a spacer
- according to: the present invention,
- Figure 12: shows an elevated view of a corresponding detail of a spacer;
- Figure 13: shows in an elevated view, and in a lateral sectional view, a spacer with continuous or connected channels and deposited glue drops;
- Figure 14: shows disconnected grooves or channels;
- Figure 15: shows disconnected grooves or channels in a spacer without and function related openings;
- Figure 16: shows the flow of air and excess glue towards the grooves;
- Figure 17: shows a spacer wafer with deep grooves and thus less prone to warping;
- Figure 18: shows a single cutout spacer element of a spacer wafer lying outside the scope of the present invention;
- Figure 19: shows a single cutout wafer stack element; and

- Figure 20: shows process steps for replicating a spacer wafer with a two-step application of glue.

The reference symbols used in the drawings, and their meanings, are listed in summary form in the list of reference symbols. In principle, identical parts are provided with the same reference symbols in the figures.

### DETAILED DESCRIPTION OF PREFERRED EMBODIMENTS

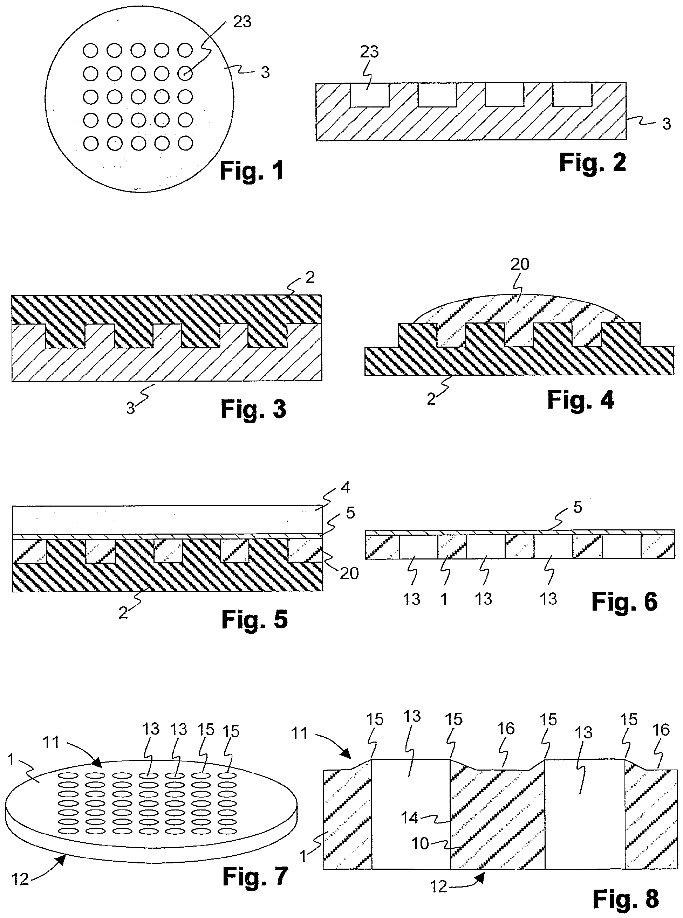

**Figure 1** shows a top view of a master form 3, and **Figure 2** shows a lateral sectional view of a section of the master form 3. The master form 3 comprises cavities 23 and has essentially the same shape as the final spacer wafer, with the exception that the some dimensions (x,y,z) are expanded to compensate any shrink that occurs during the spacer wafer fabrication process. Typically,as long as the height or thickness of the spacer wafer does not exceed a certain height, only shrink in the height of the wafer (z dimension) need to be compensated for, and shrink within the plane (x and y dimension) can be neglected. For thicker spacer wafers, e.g. more than 1 mm for certain materials, the wafer may warp during or after curing. The master form 3 can be a high precision machined part made of metal or glass or other materials. For the present purpose of fabricating a spacer wafer, the master form is preferably created by fabricating a master spacer wafer from steel or glass and then gluing it onto a flat surface made of steel or glass. The master form may be treated with a anti adhesion coating for better release of the mould tool 2 during the mould tool manufacturing step. The cavities 23 are shown as being circular with vertical side walls, but may also comprise other shapes and sloped walls, leading to correspondingly formed spacers. The cavities 23, or other features on the spacer wafer, form a grid repeating, for example, every 2 mm to 3 mm to 5 mm.

In a next step a mould tool or simply tool 2 is fabricated from the master form 3. This is done by pouring a liquid or viscous material on top of the master from 3. **Figure 3** shows a lateral sectional view of a section of a master form 3 with a tool 2 shaped from the master form 3. Once the liquid or viscous material is solidified, the tool 2 is separated from the master form 3. The tool 2 thus has the negative topography of the master 3. The tool 2 can be made of a material composite. For example, a glass back plate (not shown in the figures) can be used to increase the stiffness of the tool while a soft material is used to shape the topography of the master form. The relatively soft (compared to glass) tool material can be made of plastic such as PDMS (polydimethylsiloxan).

With the tool ready the spacer wafer fabrication can start. For that a defined amount of curable material (preferably a UV curably material such as an epoxy material) is deposited or poured onto the tool 2. **Figure 4** shows a lateral sectional view of this stage, that is, a section of a tool 2 with replication material 20 added.

Then a plate 4 is placed over the tool 2 and the replication material 20. Some pressure can be applied to the plate 4 to force the replication material 20 into the cavities of the tool 2. On the side of the plate 4 facing the spacer material 20 an anti sticking layer 5 can be applied to ease separation of the spacer wafer after curing. The anti sticking layer 5 can be a sacrificial mylar foil which is used only once for a spacer wafer. The stiff back plate 4 can be a glass plate to also let UV light pass the glass plate 4 during UV curing of the replication material 20. **Figure 5** shows a lateral sectional view of this stage, with a section of a tool 2, with replication material 20 shaped between the tool 2 and the plate 4 (or the foil 5, if it is present).

Once the spacer wafer material 20 is spread evenly into the tool 2 the whole sandwich (tool 2, cover plate 4, optional foil 5 and spacer material 20) is placed under UV light to solidify the spacer wafer material 20. After solidification the sandwich can be opened by lifting the top plate 4 and removing the spacer wafer tool 2 from the newly shaped spacer wafer 1. The tool 2 can then be filled again to fabricate the next spacer wafer 1. Typically several dozens to hundreds of spacer wafers can be fabricated from a tool. The number of spacer wafers fabricated from one tool is a function of the compatibility of the spacer wafer and tool material. For economic reasons a good compatibility of tool material and spacer wafer material is beneficial to maximize the tool lifetime.

After separation of the spacer wafer 1 from the tool, the sacrificial mylar foil 5 may stay attached to the spacer wafer 1. This mylar foil 5 can stay on the spacer wafer 1 as a protection foil during storage or further process steps. **Figure 6** shows a lateral sectional view of a section of a resulting spacer or spacer wafer 1 after curing and removing the tool 2 and plate 4. In this example, the foil 5 is shown remaining attached to the spacer 1.

In some cases a thin layer or membrane of epoxy material may form between the mylar foil 5 and the tool 2. This membrane comes off when the foil 5 is removed from the spacer 1, or can be blown out with compressed air.

**Figure 7** shows an elevated view of a spacer 1. The geometry of the spacer 1 is defined by the shape of the original master 3, except for changes in dimension due to shrinkage in the tool replication and in the spacer replication process. The spacer 1 accordingly comprises a plurality of openings 13, the openings 13 being separated from the spacer's top surface 11 and the bottom surface 12 by edges or edge regions 15.

The shrinking behavior of the replication material 20 during the curing, or, in more general terms, during the solidification process, causes the side walls around the spacer holes to remain somewhat higher than the average height of the spacer wafer 1 as a whole. This height difference can be in the range of a few micrometers, such as one to ten micrometers. **Figure 8** shows a corresponding lateral sectional view of a detail of a spacer.

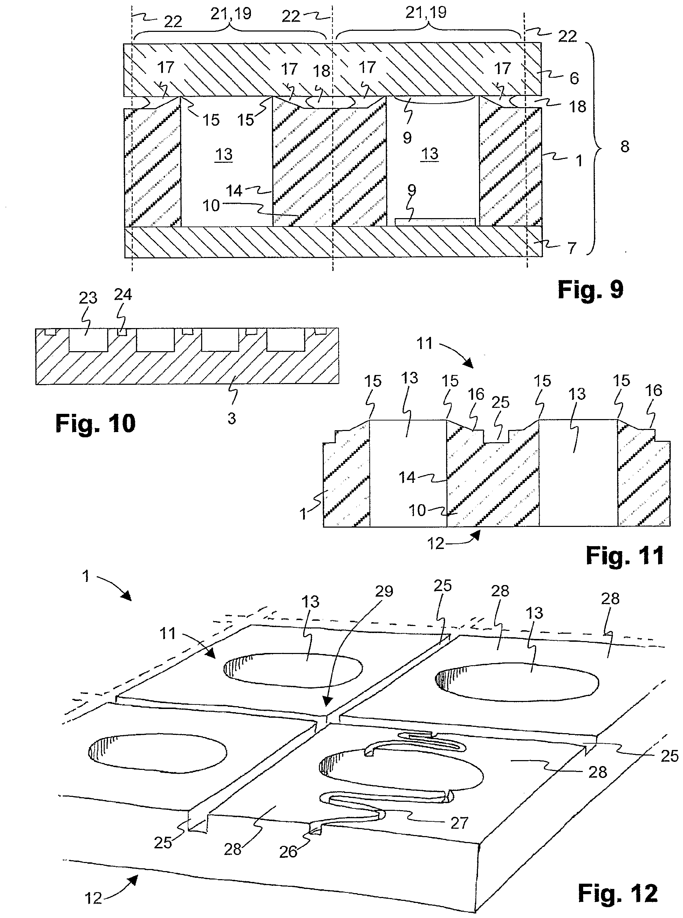

This increased height around the spacer wafer holes or openings 13 has a positive effect during the gluing of the spacer wafer 1 to a flat wafer, e.g. when forming a wafer stack 8. This is illustrated in **Figure 9****,** which shows a lateral sectional view of a detail of a wafer stack 8: Due to the effect of capillary forces, glue 17 applied to the spacer 1 surface is drawn to the thinnest part of the glue gap, that is, to the surface areas surrounding the spacer openings 13. Consequently the glue collects around the spacer openings 13, and bubbles of air 18 that may be trapped in the glue, between the spacer 1 and the adjoining top wafer 6, are forced away from the edges 15. As a result, the spacer hole cavity created by covering the opening 13 with the top wafer 6 (and bottom wafer bottom wafer 7) is sealed by the glue 17. In a further preferred embodiment of the invention, the depressions 16 are (also) formed by shaping the master 3 and the tool 2 to create the depressions 16.

Note: The top surface 11 and bottom surface 12, and the top wafer 6 and bottom wafer 7 are labeled "top" and "bottom" in order to ease the description; in more general terms they may as well be labeled "first" and "second" surface/wafer.

The trapping of air is an issue mainly when the top wafer 6 is glued to the spacer: If the bottom wafer 7 is first glued to the spacer 1, then the openings 13 are open, and glue may spill from under the spacer into the openings 13, displacing air through the openings 13. However, when the top wafer 6 is afterwards glued onto the spacer 1, then the air can no longer escape through the openings 13, since they are now closed at both ends. This is when the capillary effect caused by the elevated edges, comes into play, sealing the edges 15.

**Figure 9** also shows, by way of example, functional elements 9 in one of the cavities defined by the openings 13. In reality, typically each of the openings 13 will comprise such functional elements 9. These functional elements 9 typically are optical or electro-optical devices, such as refractive or diffractive lenses, photoreceptors, light sensitive or light emitting devices, image sensors etc. For each of the wafers, the functional elements 9 typically are identical to one another and are created by a wafer scale fabrication process, for example a replication process for forming optical elements, or an IC fabrication for forming electronical or electro-optic elements. The functional elements 9 are arranged on the top wafer 6 and/or the bottom wafer 7 prior to combining them with the spacer 1. When the wafer stack 8 is completed, which may involve additional wafers and spacers not illustrated, the wafer stack 8 is cut along dicing lines 22 into individual elements, or wafer stack elements 19, which preferably are integrated optical devices 21.

**Figure 10** shows a master 3 comprising master grooves 24 which after replication lead to spacer grooves 25 arranged around the openings 13, shown in **Figure 11****.** The spacer grooves 25 are preferably arranged along the dicing lines and serve to collect an excess of glue when the top wafer 6 is placed on the spacer 1. The spacer grooves 25 may be connected to each other and to a side of the spacer 1, or they may form isolated volumes collecting and containing the surplus glue and the air forced away from the edges or edge regions 15 by capillary forces. In a corresponding method for gluing the top wafer 6 onto the spacer 1, glue is applied only to selected regions of the top surface 11. This selective glue depositing is achieved e.g. by (silk-)screen printing or jetting (similar to jet printing in inkjet printers). The selected regions or gluing areas 28 are arranged on the top surface 11 in the surface areas left between the openings 13 and the spacer grooves 25 and optionally also venting channels 26, explained in the following:

**Figure 12** shows an elevated view of corresponding details of a spacer 1. Only four of a plurality of spacer elements are drawn. The spacer elements are separated by the spacer grooves 25 corresponding to future dicing lines. Three of the spacer elements are shown with the opening 13 completely surrounded by the top surface 11 such that, after gluing a top wafer 6 onto the spacer 1, the openings 13 will be sealed, as explained with reference to **Figure 9****.** One of the spacer elements comprises venting channels 26 in the top surface 11 leading away from the opening 13. Such an embodiment is used in applications where it the opening 13 should *not* be sealed. The venting channels 26 lead to a location that is distant from the opening 13 and are e.g. cut open when dicing the wafer stack. After the venting channels 26 are cut open, the opening 13 is open to the ambient air. The venting channels 26 preferably comprise obstacles, for example, shape features such as maeanders 27 or narrow sections. Such obstacles allow air to flow through the finished channel 26 but form an obstruction for e.g. a cooling liquid used in dicing the wafer stack, thus preventing the liquid from entering the opening 13. When applying glue to the top surface 11, the venting channels 26 are of course also excluded from the gluing area 28. Glue may be applied to the gluing surface 28 itself, but also to selected parts of the grooves 25, e.g. at intersection points 29 of the grid of grooves 25. In the latter case, when the top wafer 6 is placed on the spacer wafer 1 the glue will be drawn by capillary forces out of the grooves 25 and spread over the gluing surface 28.

In a preferred embodiment of the invention, only a single such venting channel 26 is present for each opening 13. This will prevent, when the dicing saw cuts through the venting channel 26, water to enter through the venting channel 26, since there is no second channel through which a corresponding volume of air could escape from the opening 13.

Whereas **Figure 12** shows, by way of example, two different types oft spacer elements being part of the same spacer 1, in reality usually all spacer elements will be of the same type, that is, either with or without venting channels 26.

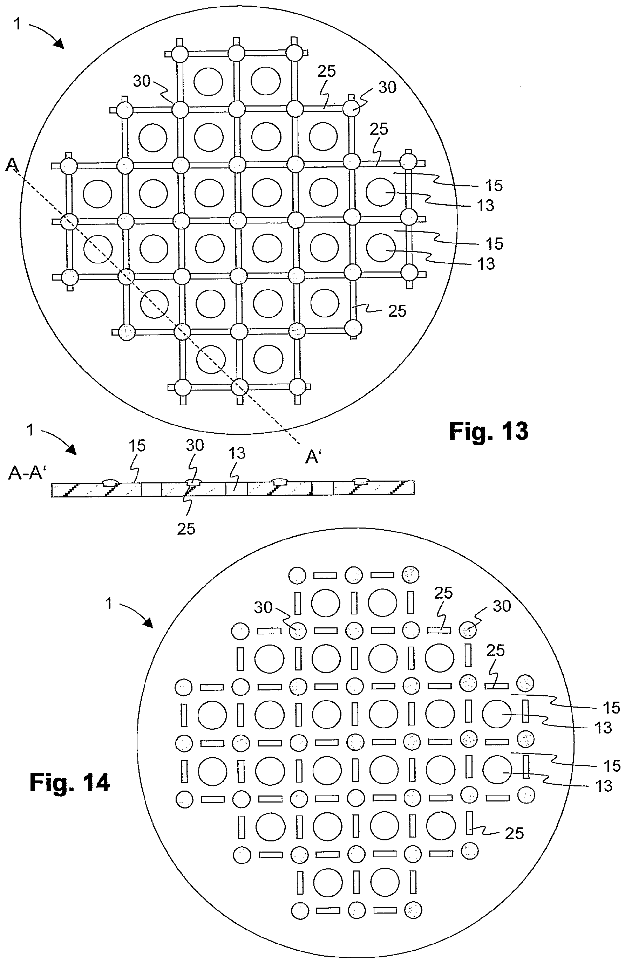

**Figure 13** shows, in an elevated view, and in a lateral sectional view A-A', similar channels or grooves 25 as in Figure 12. The sectional view A-A' schematically shows glue droplets 30 placed in or above the grooves 25 at intersections of the grooves 25. The droplets 30 may also be applied to other positions along the grooves 25, or to the edge regions 15. In all cases, the capillary forces draw the glue out of the grooves 25 into the space between another wafer placed on the spacer wafer 1, and distribute the glue between the wafers. A precondition for this approach to work is that, after placing the other wafer onto the spacer wafer 1, the glue must come into contact with the narrow space or gap between the two wafers, in order to be drawn into the gap. In order for this approach to work, the distance between the grooves 25 and other grooves 25 or openings 13 should, for liquid epoxy glue, be around 2 mm or 3 mm or 5 mm.

**Figure 14** shows, in an elevated view, further arrangements, with separated or disconnected grooves in the spacer: as opposed to the intersecting and joined grooves 25 of **Figure 12****,** the grooves 25 are disjoint. The grooves 25 serve as flow control cavities in that they control the flow of air and glue in the edge regions 15. The flow control cavities can have varied sizes and distributions over the wafer surface. The width of a flow control cavity may be from 0.05 mm to 10 mm, its depth e.g. from 0.02 mm to 10 mm, and the spacing of the cavities may be 0.1 mm to 10 mm.

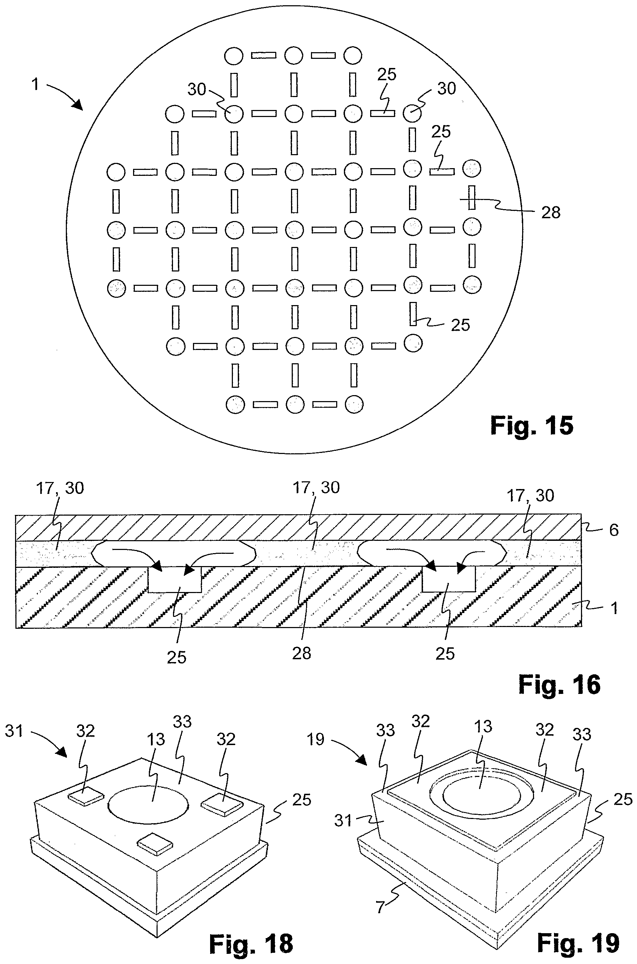

A further preferred embodiment according to **Figure 15****,** is used to glue a wafer without any openings 13 to a substrate. The grooves 25 control the flow of the glue such that, on the one hand, excess glue is collected in the grooves, and, on the other hand, any trapped air is collected in the grooves 25. This allows to control the location of air bubbles such that predetermined gluing areas 28 of the glue layer are air free. This flow control is of course also accomplished with intersecting and joined grooves. **Figure 16** schematically shows, in a lateral sectional view, indicated by arrows, the flow of air and excess glue 17 towards the grooves 25, if the glue 17 is placed at locations away from the grooves 25 (or openings 13).

Whereas the examples shown are based on droplet deposition, i.e. single drops of glue being deposited individually, the invention is just as well applicable when the glue is deposited along a line or a plurality of line sections. Such a line may be a straight line or a maeandering line.

In principle, the flow effects, geometric features 15, 16, 25 and glue placement explained with reference to **Figures 11** to **16** are applicable to any kind of wafer, not only to spacer wafers 1 made in a replication process. However, the replication process makes it particularly easy to manufacture spacer wafers 1 with the geometric features for controlling glue flow.

If the wafer is to be cut later in the manufacturing process, then the grooves 25 are again preferably placed coincident with the dicing lines 22.

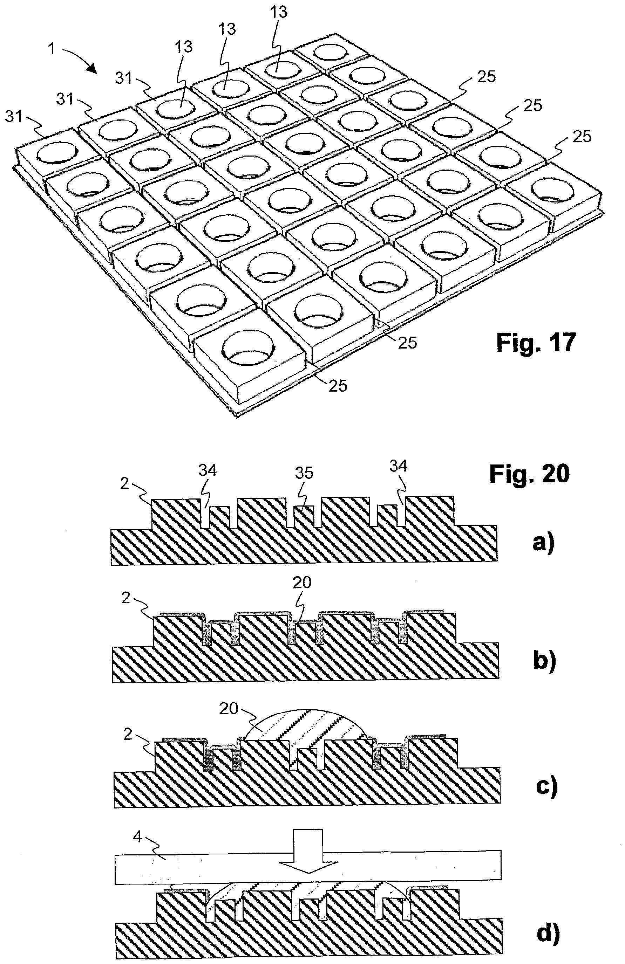

In a further preferred embodiment of the invention, the depth of the grooves 25 is at least half or up to 80% or more of the thickness of the spacer wafer 1. In absolute terms, for a spacer wafer of e.g. 1 mm to 1.5 mm or 2mm, the grooves or channels 25 are preferebly so deep that the remaining material holding the wafer together has a thickness of 0.2 mm to 0.4 mm to 0.5 mm. **Figure 17** schematically shows a view of a section of such a spacer wafer 1, with deep grooves 25 defining the remaining material as mesa-like spacer elements 31. Having such deep grooves 25 prevents the spacer wafer 1 from warping and excess shrinkage. With dicing lines 22 being conicident with the deep grooves 25, the dicing process creates less wear on the saws, and may be simplified.

**Figure 18** shows a single spacer element 31, separated from a wafer. The top surface 33 of the spacer element 31 comprises micro-spacers 32 protruding from the top surface 33. The height by which they protrude is preferably around 20 micrometers, that is, between 10 or 15 to 25 or 35 micrometers. Since the deep grooves 25 in this embodiment may be too deep to deposit glue 17 prior to joining the spacer wafer 1 to the top wafer 6, the glue 17 is preferably applied to the top surface 33. The micro-spacers 32 define a precise distance at which the top wafer 6 comes to rest against the spacer wafer 1. The micro-spacers 32 correspond, as far as the flow of the glue is concerned, to the edges 15 of Fig. 11, and the remaining top surface 33 corresponds to the depressions 16 of Fig. 11. These top surfaces 33 may also be considered to be local flow control cavities 33, that is, flow control cavities that are local to the spacer area of a particular mesa corresponding to one wafer stack element 19. The top surfaces may also comprise one or more venting channels as shown in **Figure 12****.**

An intermediate product without a top wafer 6 may be fabricated and diced, i.e. cut into separate wafer stack elements 19. A resulting wafer stack element 19 thus comprises at least a cutout part of a bottom wafer 7 (e.g. with an optical or electronic element) and a spacer wafer 1. This wafer stack element 19 can be, individually and in a separate, later process, be glued to another object by the free top surface of the spacer wafer. The flow control cavities then also provide their function.

**Figure 19** shows such a single cutout wafer stack element 19, cut out from a wafer stack and comprising at least a cutout part of a bottom wafer 7 and of a spacer element 31. The spacer element shown here comprises a micro-spacer 32 which covers almost the entire top surface of the spacer element 31, but is distanced from the original groove 25 and the dicing line corresponding to the groove 25 by a small ledge forming the remaining top surface 33. This ledge corresponds to the depressed region 16 shown in **Figures 9** and **11****.** Thus, one more micro-spacers 32 are arranged on at least one of the first and second surface 11, 12 and being distanced from the dicing lines 22 by a predetermined distance.

Of course, such a wafer stack element 19 may also be fabricated with a spacer shaped as in Figure 18.

The fact that the micro-spacers 32, as in **Figures 18** and **19****,** are distanced from the dicing lines provides the additional advantage that the dicing saw does not disturb the topmost surface (i.e. the top surface of the micro-spacers 32) of the spacer wafer or of the single wafer stack element 19. Any jagged edges produced by the dicing saw cutting into the main body of the spacer element 31 will be confined to the area of the remaining top surface 33, which is lower than that of the micro-spacers 32. As a result, such non-ideal edges do not interfere when glueing the the top surface to another element. The width of the ledge is, for example, between 100 and 300 micrometers, and its height as that of the micro-spacers 32 described with reference to **Figure 18****.**

**Figure 20** illustrates process steps for replicating a spacer wafer 1 comprising deep features such as deep grooves 25, and correspondingly relatively thin and high spacer elements 31 in a tool, provided in step a). These spacer elements 31 correspond to deep spacer element negatives 34 in the tool 2. The deep grooves 25 correspond to high ridges 35 in the tool 2. The replication step illustrated in Figure 4, i.e. the deposition of a blob of spacer material 20 on the tool 2 and spreading the spacer material 20 on the tool 2 may cause air to be trapped in the deeper features 34 of the tool 2. For this reason, in a preferred variant of the invention, in a first depositing step b), the spacer material or replication material 20 is sprayed on to the tool 2, covering the entire replication surface of the tool 2 with a thin layer. Preferably, deeper features 34 get at least partially filled up in this step as well.

In a subsequent depositing step c), the replication material 20 is placed or poured on the tool, preferably near the middle of the tool. In further step d), the replication material 20 flows outward over the tool 2, driven by gravity and/or the plate 4 as the plate 4 is moved relative to the tool 2 towards the tool 2, as indicated by the arrow. Alternatively, the tool 2 may be dipped in replication material, filling the remaining cavities.

The same process is of course applicable to the creation of the tool 2 itself from the master 3, and to any other replication process in which deep features need to be filled.

While the invention has been described in present preferred embodiments of the invention, it is distinctly understood that the invention is not limited thereto, but may be otherwise variously embodied and practised within the scope of the claims.

### LIST OF DESIGNATIONS

| | | | |
|---|---|---|---|
| 1 | spacer | 19 | wafer stack element |
| 2 | tool | 20 | spacer material |
| 3 | master | 21 | optical device |
| 4 | back plate | 22 | dicing lines |
| 5 | foil, anti adhesion layer | 23 | cavities |
| 6 | top wafer | 24 | groove in master |
| 7 | bottom wafer | 25 | groove in spacer or wafer |
| 8 | wafer stack | 26 | venting channel |
| 9 | functional element | 27 | maeander |
| 10 | spacer body | 28 | gluing area |
| 11 | top surface | 29 | intersection point |
| 12 | bottom surface | 30 | glue droplet |
| 13 | opening | 31 | spacer element |
| 14 | side wall | 32 | micro-spacer |
| 15 | edge | 33 | top surface |
| 16 | depression | 34 | spacer element negative |
| 17 | glue | 35 | ridge |
| 18 | air | | |

## Claims

1. A spacer wafer (1), suitable to be incorporated in a wafer stack (8), the wafer stack (8) comprising at least a first wafer (6) carrying a plurality of functional elements (9) and a second wafer (7) carrying a plurality of functional elements (9) aligned with the functional elements (9) of the first wafer (6), the wafer stack (8) being separable into a plurality of integrated optical devices (21), the spacer wafer (1) comprising
a spacer body (10) with a first surface (11) and a second surface (12), the spacer wafer (1) being shaped to keep the first wafer (6) placed against the first surface (11) and the second wafer (7) placed against the second surface (12) at a constant distance from each other, the spacer wafer (1) comprising a plurality of openings (13) surrounded by the first surface (11) and the second surface (12) and arranged for alignment with the functional elements of the first wafer and of the second wafer, the spacer wafer (1) further comprising a plurality of cavities (25) in at least the first surface (11),
wherein the cavities (25) are suitable to collect excess glue when the spacer wafer (1) is glued against the first wafer (6),
wherein these cavities (25) are grooves (25) arranged on at least one of the first and second surface (11, 12) between the openings (13) and separated from the openings (13) by edge regions (15),
Wherein the spacer wafer (1) is suitable for separating two wafers of the wafer stack (8),
**characterized in that**
at least one of the first and second surface (11, 12) comprises edge regions (15) separating said surface (11, 12) from the openings (13), and wherein the thickness of the spacer wafer (1) at the edge regions (15) exceeds the thickness of the spacer wafer (1) at surface locations around the edge regions (16, 25),
wherein the surface (11) forms a depression (16) with regard to the edge regions (15).

2. The wafer (1) of claim 1, wherein the difference in thickness at the edge regions (15) and at the surface locations around the edge regions (15) is in the range of one to ten micrometers.

3. The wafer (1) according to claim 1 or 2, wherein the grooves (25) are coincident with dicing lines (22) for separating the wafer stack (8) into individual devices (21).

4. The wafer (1) according to any one of the preceding claims, wherein the depth of the grooves (25) is at least 50% to 80% or 90% of the height of the spacer (1).

5. The wafer (1) according to one of the preceding claims, wherein the wafer (1) is manufactured by means of moulding, embossing or stamping.

6. The spacer wafer (1) according to any one of the preceding claims, comprising venting channels (26) shaped in a surface (11, 12) of the spacer (1) leading from the openings (13) to locations of said surface which are distant from the respective openings (13).

7. The spacer wafer (1) of claim 6, wherein the venting channels (26) comprise obstacles to obstruct a flow of material through the venting channels (26).

8. The spacer wafer (1) of any preceding claim, wherein the openings (13) are completely surrounded by the first surface (11).

9. A wafer stack (8), comprising at least a first wafer (6) carrying a plurality of functional elements (9), a second wafer (7) carrying a plurality of functional elements (9) aligned with the functional elements (9) of the first wafer (6), and the spacer wafer (1) according to one of the preceding claims, wherein the cavities (25) comprise excess glue from gluing the spacer wafer (1) against the first wafer (6).

10. A method of manufacturing a wafer stack element (19) comprising providing a wafer stack (8) according to claim 9 followed by separating the wafer stack (8) into a plurality of wafer stack elements (19).

## Patentansprüche

1. Abstandshalter-Wafer (1), der geeignet ist, in einen Waferstapel (8) einbezogen zu werden, wobei der Waferstapel (8) mindestens einen ersten Wafer (6), der eine Vielzahl von Funktionselementen (9) trägt, und einen zweiten Wafer (7), der eine Vielzahl von Funktionselementen (9) trägt, die mit den Funktionselementen (9) des ersten Wafers (6) ausgerichtet sind, umfasst, wobei der Waferstapel (8) in eine Vielzahl von integrierten optischen Vorrichtungen (21) trennbar ist, wobei der Abstandshalter-Wafer (1) Folgendes umfasst:
einen Abstandshalterkörper (10) mit einer ersten Oberfläche (11) und einer zweiten Oberfläche (12), wobei der Abstandshalter-Wafer (1) so geformt ist, dass der gegen die erste Oberfläche (11) platzierte erste Wafer (6) und der gegen die zweite Oberfläche (12) platzierte zweite Wafer (7) in einem konstanten Abstand voneinander gehalten werden, wobei der Abstandshalter-Wafer (1) eine Vielzahl von Öffnungen (13) umfasst, die von der ersten Oberfläche (11) und der zweiten Oberfläche (12) umgeben und zur Ausrichtung mit den Funktionselementen des ersten Wafers und des zweiten Wafers angeordnet sind, wobei der Abstandshalter-Wafer (1) ferner eine Vielzahl von Hohlräumen (25) mindestens in der ersten Oberfläche (11) umfasst,
wobei die Hohlräume (25) geeignet sind, überschüssigen Klebstoff zu sammeln, wenn der Abstandshalter-Wafer (1) gegen den ersten Wafer (6) geklebt ist,
wobei diese Hohlräume (25) Rillen (25) sind, die auf mindestens einer der ersten und der zweiten Oberfläche (11, 12) zwischen den Öffnungen (13) angeordnet und von den Öffnungen (13) durch Randbereiche (15) getrennt sind,
wobei der Abstandshalter-Wafer (1) zum Trennen von zwei Wafern des Waferstapels (8) geeignet ist,
**dadurch gekennzeichnet, dass** mindestens eine der ersten und der zweiten Oberfläche (11, 12) Randbereiche (15) umfasst, welche die Oberfläche (11, 12) von den Öffnungen (13) trennen, und wobei die Dicke des Abstandshalter-Wafers (1) an den Randbereichen (15) die Dicke des Abstandshalter-Wafers (1) an Oberflächenstellen (16, 25) um die Randbereiche übersteigt,
wobei die Oberfläche (11) eine Vertiefung (16) in Bezug auf die Randbereiche (15) bildet.

2. Wafer (1) nach Anspruch 1, wobei die Differenz der Dicken an den Randbereichen (15) und an den Oberflächenstellen um die Randbereiche (15) im Bereich von einem bis zehn Mikrometern liegt.

3. Wafer (1) nach Anspruch 1 oder 2, wobei die Rillen (25) mit Vereinzelungslinien (22) zum Trennen des Waferstapels (8) in einzelne Vorrichtungen (21) übereinstimmen.

4. Wafer (1) nach einem der vorhergehenden Ansprüche, wobei die Tiefe der Rillen (25) mindestens 50 % bis 80 % oder 90 % der Höhe des Abstandshalters (1) beträgt.

5. Wafer (1) nach einem der vorhergehenden Ansprüche, wobei der Wafer (1) mittels Gießens, Prägens oder Stanzens hergestellt wird.

6. Abstandshalter-Wafer (1) nach einem der vorhergehenden Ansprüche, in einer Oberfläche (11, 12) des Abstandshalters (1) geformte Entlüftungskanäle (26) umfassend, die von den Öffnungen (13) zu Stellen der Oberfläche führen, die von den jeweiligen Öffnungen (13) entfernt sind.

7. Abstandshalter-Wafer (1) nach Anspruch 6, wobei die Entlüftungskanäle (26) Hindernisse umfassen, um einen Fluss von Material durch die Entlüftungskanäle (26) zu behindern.

8. Abstandshalter-Wafer (1) nach einem der vorhergehenden Ansprüche, wobei die Öffnungen (13) vollständig von der ersten Oberfläche (11) umgeben sind.

9. Waferstapel (8), umfassend mindestens einen ersten Wafer (6), der eine Vielzahl von Funktionselementen (9) trägt, einen zweiten Wafer (7), der eine Vielzahl von Funktionselementen (9) trägt, die mit den Funktionselementen (9) des ersten Wafers (6) ausgerichtet sind, und den Abstandshalter-Wafer (1) nach einem der vorhergehenden Ansprüche, wobei die Hohlräume (25) überschüssigen Klebstoff vom Kleben des Abstandshalter-Wafers (1) gegen den ersten Wafer (6) umfassen.

10. Verfahren zum Herstellen eines Waferstapel-Elements (19), umfassend das Bereitstellen eines Waferstapels (8) nach Anspruch 9, gefolgt vom Trennen des Waferstapels (8) in eine Vielzahl von Waferstapel-Elementen (19).

## Revendications

1. Plaquette d'espaceur (1), adaptée pour être incorporée dans un empilement de plaquettes (8), l'empilement de plaquettes (8) comprenant au moins une première plaquette (6) portant une pluralité d'éléments fonctionnels (9) et une deuxième plaquette (7) portant une pluralité d'éléments fonctionnels (9) alignés avec les éléments fonctionnels (9) de la première plaquette (6), l'empilement de plaquettes (8) pouvant être séparé en une pluralité de dispositifs optiques intégrés (21), la plaquette d'espaceur (1) comprenant
un corps d'espaceur (10) comportant une première surface (11) et une deuxième surface (12), la plaquette d'espaceur (1) étant formée pour maintenir la première plaquette (6) placée contre la première surface (11) et la deuxième plaquette (7) placée contre la deuxième surface (12) à une distance constante l'une de l'autre, la plaquette d'espaceur (1) comprenant une pluralité d'orifices (13) entourés par la première surface (11) et la deuxième surface (12) et agencés pour être alignés avec les éléments fonctionnels de la première plaquette et de la deuxième plaquette, la plaquette d'espaceur (1) comprenant en outre une pluralité de cavités (25) dans au moins la première surface (11),
dans laquelle les cavités (25) sont adaptées pour collecter de la colle en excès lorsque la plaquette d'espaceur (1) est collée contre la première plaquette (6),
dans laquelle ces cavités (25) sont des rainures (25) agencées sur au moins l'une de la première et de la deuxième surface (11, 12) entre les orifices (13) et séparées des orifices (13) par des régions de bord (15),
dans laquelle la plaquette d'espaceur (1) est adaptée pour séparer deux plaquettes de l'empilement de plaquettes (8),
**caractérisée en ce qu'**au moins l'une parmi la première surface et le deuxième surface (11, 12) comprend des régions de bord (15) séparant ladite surface (11, 12) des orifices (13), et dans laquelle l'épaisseur de la plaquette d'espaceur (1) au niveau des régions de bord (15) est supérieure à l'épaisseur de la plaquette d'espaceur (1) au niveau d'emplacements de surface autour des régions de bord (16, 25),
dans laquelle la surface (11) forme un creux (16) par rapport aux régions de bord (15).

2. Plaquette (1) selon la revendication 1, dans laquelle la différence d'épaisseur au niveau des régions de bord (15) et au niveau des emplacements de surface autour des régions de bord (15) est dans la plage allant d'un à dix micromètres.

3. Plaquette (1) selon la revendication 1 ou 2, dans laquelle les rainures (25) coïncident avec des lignes de découpage en dés (22) destinées à séparer l'empilement de plaquettes (8) en des dispositifs individuels (21).

4. Plaquette (1) selon l'une quelconque des revendications précédentes, dans laquelle la profondeur des rainures (25) est d'au moins 50 % à 80 % ou 90 % de la hauteur de l'espaceur (1).

5. Plaquette (1) selon l'une quelconque des revendications précédentes, dans laquelle la plaquette (1) est fabriquée par moulage, gaufrage ou estampage.

6. Plaquette d'espaceur (1) selon l'une quelconque des revendications précédentes, comprenant des canaux d'aération (26) formés dans une surface (11, 12) de l'espaceur (1) conduisant des orifices (13) à des emplacements de ladite surface qui sont distants des orifices respectifs (13).

7. Plaquette d'espaceur (1) selon la revendication 6, dans laquelle les canaux d'aération (26) comprennent des obstacles pour entraver un écoulement de matière à travers les canaux d'aération (26).

8. Plaquette d'espaceur (1) selon l'une quelconque des revendications précédentes, dans laquelle les orifices (13) sont entièrement entourés par la première surface (11).

9. Empilement de plaquettes (8), comprenant au moins une première plaquette (6) portant une pluralité d'éléments fonctionnels (9), une deuxième plaquette (7) portant une pluralité d'éléments fonctionnels (9) alignés avec les éléments fonctionnels (9) de la première plaquette (6), et la plaquette d'espaceur (1) selon l'une quelconque des revendications précédentes, dans lequel les cavités (25) comprennent de la colle en excès provenant du collage de la plaquette d'espaceur (1) contre la première plaquette (6).

10. Procédé de fabrication d'un élément d'empilement de plaquettes (19) comprenant la fourniture d'un empilement de plaquettes (8) selon la revendication 9 suivie d'une séparation de l'empilement de plaquettes (8) en une pluralité d'éléments d'empilement de plaquettes (19).
